# EUROPEAN PATENT SPECIFICATION

(11) **EP 3 128 535 B1**
(45) Date of publication and mention of the grant of the patent: **03.06.2020**
(21) Application number: 15773856.8
(22) Date of filing: 10.03.2015
(51) Int. Cl.: H01L 21/302, H01L 21/205, C30B 29/36, C30B 33/08

(54) **SURFACE TREATMENT METHOD FOR SIC SUBSTRATES AND SEMICONDUCTOR PRODUCTION METHOD**
OBERFLÄCHENBEHANDLUNGSVERFAHREN FÜR SIC-SUBSTRATE UND HALBLEITERHERSTELLUNGSVERFAHREN
PROCÉDÉ DE TRAITEMENT DE SURFACE POUR SUBSTRATS SIC ET PROCÉDÉ DE FABRICATION DE COMPOSANTS À SEMI-CONDUCTEUR

(30) Priority: 31.03.2014 JP 2014074749
(43) Date of publication of application: 08.02.2017
(73) Proprietor: Toyo Tanso Co., Ltd., Osaka-shi, Osaka 555-0011 (JP)
(72) Inventor: TORIMI, Satoshi, Kanonji-shi Kagawa 769-1612 (JP); YABUKI, Norihito, Kanonji-shi Kagawa 769-1612 (JP); NOGAMI, Satoru, Kanonji-shi Kagawa 769-1612 (JP)
(74) Representative: TBK
(86) International application number: PCT/JP2015/001303
(87) International publication number: WO 2015/151413

(56) References cited:
- WO-A1-2014/199614
- JP-A- 2003 234 313
- JP-A- 2004 002 126
- JP-A- 2008 230 944
- JP-A- 2009 256 145
- US-A1- 2013 183 820

## Description

### TECHNICAL FIELD

The present invention mainly relates to a surface treatment method for removing latent scratches of a SiC substrate.

### BACKGROUND ART

SiC, which is superior to Si, etc., in terms of heat resistance, mechanical strength, and the like, has been attracting attention as a new semiconductor material.

Patent Document 1 discloses a surface treatment method for planarizing a SiC substrate. In the surface treatment method, a storage container is heated while the SiC substrate is stored within the storage container under Si vapor pressure. This results in etching the SiC substrate stored within the storage container, to obtain the SiC substrate that is planar at a molecular level.

Here, the SiC substrate can be obtained by cutting out from an ingot made of a single crystal SiC in a predetermined angle. Since the surface roughness of the cut substrate is large, the surface needs to be planarized by performing a mechanical polishing (MP), a chemical mechanical polishing (CMP) and the like. However, performing the mechanical polishing generates polishing scratches on the SiC substrate. Applying the pressure to the surface of the SiC substrate during the mechanical polishing generates a modified layer (hereinafter, referred to as latent scratches) in which the crystallinity is disturbed.

Patent Document 2 discloses a treatment method for removing a surface modified layer formed on the SiC substrate. Patent Document 2 describes that the surface modified layer is a damage layer of a crystal structure occurred in a step of manufacturing the SiC substrate. Patent Document 2 describes that the surface modified layer is kept equal to or less than 50nm and the surface modified layer is removed by hydrogen etching.

Patent Document 3 discloses a surface treatment method including heating, in a high vacuum environment, a SiC substrate having a damaged layer generated during polishing to form a carbonized layer on the substrate, heating the SiC substrate having the carbonized layer under Si atmosphere to form an amorphous SiC layer on the SiC substrate, and removing the amorphous SiC layer on the SiC substrate by thermal etching. Patent Document 4 discloses a surface treatment method including heating, in an inert gas atmosphere, a SiC substrate having a polished surface to form a carbon layer thereon, thermally oxidizing the carbon layer on the SiC substrate to form an oxide film on the SiC substrate, and thermally etching the oxide film.

Patent Documents 5 discloses a surface treatment method of heating, in an inert gas atmosphere, a SiC substrate machined from a single crystal ingot. Patent Document 6 discloses a surface treatment method of heating, under the presence of a polycrystalline SiC body, SiC powder and Ta plates in a nitrogen atmosphere, a SiC substrate cut out from a single crystal.

### PRIOR-ART DOCUMENTS

### PATENT DOCUMENTS

PATENT DOCUMENT 1: JP 2008 016691 A
PATENT DOCUMENT 2: WO 2011/024931 A1
PATENT DOCUMENT 3: JP 2008 230944 A
PATENT DOCUMENT 4: JP 2004 002126 A
PATENT DOCUMENT 5: JP 2009 256145 A
PATENT DOCUMENT 6: JP 2003 234313 A

### SUMMARY OF THE INVENTION

### PROBLEMS TO BE SOLVED BY THE INVENTION

Here, when etching treatment, heat treatment and the like are performed on a SiC substrate having remaining latent scratches, the latent scratches are spread and extended through an epitaxial film and then a surface of the SiC substrate is roughened. As a result, a quality of a semiconductor manufactured from the SiC substrate is degraded. However, the rate of etching in a conventional hydrogen etching is several tens of nm/h to several hundreds of nm/h, and therefore it takes a lot of time for removing the latent scratches of about a few µm. The rate of polishing in the chemical mechanical polishing is 1 µm/h or less, and therefore it takes a lot of time for removing the latent scratches.

Patent Document 1 does not describe about the latent scratches, but if the SiC substrate is heated and etched by a method described in Patent Document 1, the latent scratches can be quickly removed. Performing the heat treatment in high-vacuum Si atmosphere, however, may cause too much removal of the substrate because the rate of etching is high.

The thickness of the surface modified layer can be small by a method described in Patent Document 2. However, it is required that the SiC substrate is grown from a seed crystal by using a predetermined material. This decreases the degree of freedom in a processing step and increases the labor in the processing step.

The present invention has been made in view of the circumstances described above, and a primary object of the present invention is to provide a surface treatment method for quickly removing latent scratches occurred on a SiC substrate in a necessary and sufficient range.

### MEANS FOR SOLVING THE PROBLEMS AND EFFECTS THEREOF

Problems to be solved by the present invention are as described above, and next, means for solving the problems and effects thereof will be described.

In a first aspect of the present invention, there is provided a surface treatment method according to claim 1. Therefore, the surface is not roughened when an epitaxial growth and heat treatment or the like are performed. This can manufacture a high-quality SiC substrate. The etching by the above-described method can considerably shorten a treatment time than that of the mechanical polishing, the chemical mechanical polishing and the hydrogen etching. Moreover, the rate of etching can be adjusted by adjusting the inert gas pressure, which can prevent too much removal of the SiC substrate.

In the surface treatment method of the SiC substrate, the latent scratches are existing on the SiC substrate after the mechanical processing is performed. The latent scratches are removed by the step of heating and etching the SiC substrate under the Si atmosphere and under the condition that the inert gas pressure is 0.01 Pa or more and 1 Pa or less and the temperature is 1800°C or more and 2000°C or less.

This can appropriately remove the latent scratches on the surface of the SiC substrate.

In the surface treatment method of the SiC substrate, it is preferable that the surface of 5µm or more on the SiC substrate is removed by the step of heating and etching the SiC substrate under the Si atmosphere.

This can remove a certain amount of latent scratches. Particularly, in this embodiment, the rate of etching can be adjusted using the inert gas pressure, and therefore the latent scratches within a necessary and sufficient range can be removed.

In the surface treatment method of the SiC substrate, it is preferable that the rate of etching in a case of etching on the SiC substrate is controlled equal to or more than 200nm/min, and also the amount of etching of the SiC substrate is controlled equal to or more than 10µm.

This can suppress a step bunching which may be existing after etching under Si atmosphere.

In a second aspect of the present invention, a method for manufacturing a semiconductor as specified in claim 4 is provided. That is, the method for manufacturing the semiconductor includes a latent scratches removal step, an epitaxial growth step and a heat treatment step. In the latent scratches removal step, the surface of the SiC substrate is etched by the surface treatment method. In the epitaxial growth step, the epitaxial growth of a single crystal SiC is caused on the surface of a SiC substrate where the latent scratches are removed in the latent scratches removal step. In the heat treatment step, the SiC substrate after performing the epitaxial growth step is heated under Si atmosphere.

Accordingly, the surface is not roughened when the epitaxial growth and heat treatment and the like are performed, which can manufacture a high-quality semiconductor.

For a method for manufacturing the semiconductor, in the heat treatment step, it is preferable that the SiC substrate is heated under Si atmosphere and then etched while controlling the rate of etching of the SiC substrate by adjusting the inert gas pressure around the SiC substrate.

Thus, both the latent scratches removal step and the heat treatment step perform the same treatment. This can simplify the steps and can easily perform the processing in the same apparatus.

### BRIEF DESCRIPTION OF THE DRAWINGS

[Fig. 1] A diagram for illustration of an outline of a high-temperature vacuum furnace for use in a surface treatment method according to the present invention.
[Fig. 2] Diagrams schematically showing the appearance of a substrate in each step.
[Fig. 3] A graph showing a relationship between the heating temperature and the rate of etching.
[Fig. 4] A graph showing a relationship between the inert gas pressure and the rate of etching for each of heating temperatures.
[Fig. 5] Another graph showing a relationship between the inert gas pressure and the rate of etching for each of heating temperatures.
[Fig. 6] Photomicrographs of a differential interference microscope of a SiC substrate after etched under various heating temperatures and various pressures.
[Fig. 7] Diagrams showing three-dimensional shapes of the SiC substrate after etched under various heating temperatures and various pressures.
[Fig. 8] A graph showing Arrhenius plot of the rate of etching.
[Fig. 9] A graph showing the relationship between the amount of etching and the surface roughness of the substrate after etching.
[Fig. 10] A graph showing the relationship between the amount of etching and a peak shift in Raman spectroscopy.
[Fig. 11] Photomicrographs of the surface of the SiC substrate in a case where the amount of etching is substantially constant and other conditions are changed.
[Fig. 12] Photomicrographs of the surface of the SiC substrate in a case where the amount of etching is relatively small and other conditions are changed.
[Fig. 13] Photomicrographs of the surface of the SiC substrate in a case where the rate of etching is substantially constant and other conditions are changed.
[Fig. 14] A graph showing a measurement result whether a step bunching is suppressed or occurred in a case where the rate of etching and the amount of etching are changed.

### EMBODIMENT FOR CARRYING OUT THE INVENTION

Next, an embodiment of the present invention will be described with reference to the drawings.

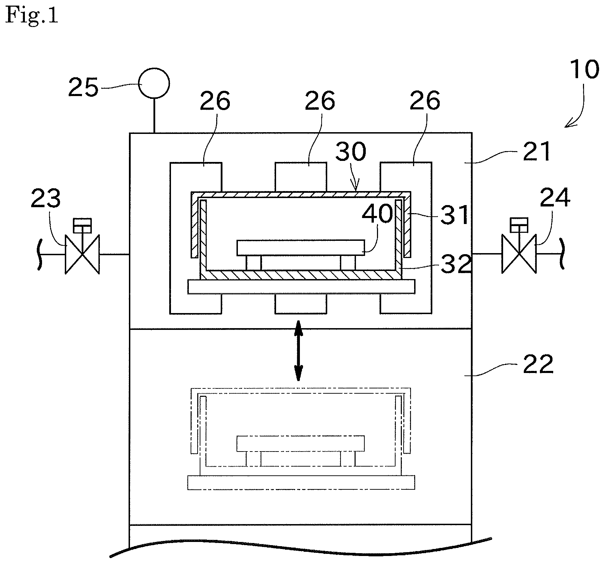

Firstly, a high-temperature vacuum furnace 10 that is used in a heat treatment of this embodiment will be described with reference to Fig. 1. Fig. 1 is a diagram for illustration of an outline of a high-temperature vacuum furnace for use in a surface treatment method according to the present invention.

As shown in Fig. 1, the high-temperature vacuum furnace 10 includes a main heating chamber 21 and a preheating chamber 22. The main heating chamber 21 is configured to heat a SiC substrate made of, at least in its surface, single crystal SiC, up to a temperature of 1000°C or more and 2300°C or less. The preheating chamber 22 is a space for preheating the SiC substrate prior to heating of the SiC substrate in the main heating chamber 21.

A vacuum-forming valve 23, an inert gas injection valve 24, and a vacuum gauge 25 are connected to the main heating chamber 21. The vacuum-forming valve 23 is configured to adjust the degree of vacuum of the main heating chamber 21. The inert gas injection valve 24 is configured to adjust pressure of an inert gas (for example, Ar gas) contained in the main heating chamber 21. The vacuum gauge 25 is configured to measure the degree of vacuum within the main heating chamber 21.

Heaters 26 are provided in the main heating chamber 21. Heat reflection metal plates (not shown) are secured to a side wall and a ceiling of the main heating chamber 21. The heat reflection metal plates are configured to reflect heat of the heaters 26 toward a central region of the main heating chamber 21. This provides strong and uniform heating of the SiC substrate, to cause a temperature rise up to 1000°C or more and 2300°C or less. Examples of the heaters 26 include resistive heaters and high-frequency induction heaters.

The SiC substrate is heated while stored in a crucible (storing container) 30. The crucible 30 is placed on an appropriate support or the like, and the support is movable at least in a range from the preheating chamber to the main heating chamber.

The crucible 30 includes an upper container 31 and a lower container 32 that are fittable with each other. The crucible 30 is made of tantalum metal, and includes a tantalum carbide layer that is exposed to an internal space of the crucible 30.

To perform a heat treatment on the SiC substrate, as indicated by a chain line in Fig. 1, the crucible 30 is placed in the preheating chamber 22 of the high-temperature vacuum furnace 10, and preheated at a proper temperature (for example, about 800°C). Then, the crucible 30 is moved into the main heating chamber 21 in which the temperature has been preliminarily raised to a set temperature (for example, about 1800°C), and the SiC substrate is heated. The preheating may be omitted.

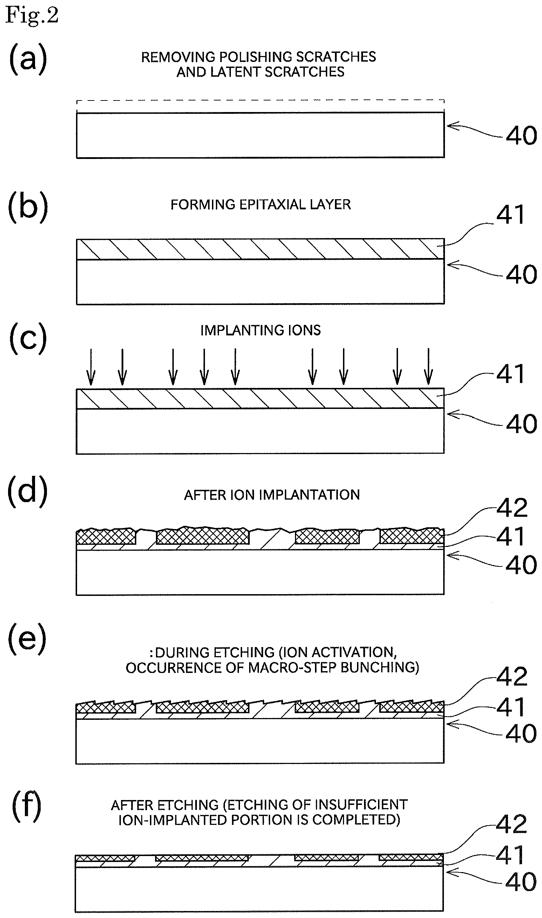

Next, a process of manufacturing a semiconductor element from a SiC substrate 40 by using the above-described high-temperature vacuum furnace 10 will be described with reference to Fig. 2. Fig. 2 contains diagrams each schematically showing the appearance of a substrate in each step.

A bulk substrate used for manufacturing a semiconductor element can be obtained by cutting an ingot made of 4H-SiC single crystal or 6H-SiC single crystal in a predetermined thickness. Particularly, the bulk substrate having an off angle can be obtained by obliquely cutting the ingot. Then, the mechanical polishing is performed for removing the surface roughness of the bulk substrate. However, the pressure is applied to the inside of the bulk substrate by performing the mechanical polishing, which causes a modified layer (latent scratch) in which the crystallinity is changed.

Next, as shown in Fig. 2(a), the surface of the SiC substrate 40 is etched by using the high-temperature vacuum furnace 10. The etching is performed by heating the SiC substrate stored in the crucible 30 under Si vapor pressure (under Si atmosphere) in an environment of 1800°C or more and 2000°C or less. As a result of heating under Si vapor pressure, SiC of the SiC substrate 40 is sublimated into Si₂C or SiC₂, and Si under Si atmosphere and C are bonded on the surface of the SiC substrate 40. This leads to self-organization and planarization of the surface.

Accordingly, the surface of the SiC substrate 40 can be planarized at a molecular level while etching the surface of the SiC substrate 40. In a case that polishing scratches and latent scratches are existing on the SiC substrate 40, the polishing scratches and latent scratches can be removed by etching. In this embodiment, since the rate of etching can be controlled by adjusting the inert gas pressure, too much removal of the SiC substrate can be prevented while sufficiently removing latent scratches (details thereof will be described later).

The chemical mechanical polishing can be omitted by etching according to this embodiment. Therefore, the latent scratches can be removed without changing a conventional effort.

Next, as shown in Fig. 2(b), an epitaxial layer 41 is formed on the SiC substrate 40. Any method is adoptable for forming an epitaxial layer. For example, the known vapor phase epitaxy, liquid-phase epitaxial method or the like may be adoptable. If the SiC substrate 40 is an off-angled substrate, the CVD process that forms the epitaxial layer based on a step-flow control is also adoptable.

Then, as shown in Fig. 2(c), the SiC substrate 40 having the epitaxial layer 41 formed thereon is implanted with ions. This ion implantation is performed with an ion-doping apparatus having a function of irradiating an object with ions. The ion-doping apparatus selectively implants ions in the whole or a part of the surface of the epitaxial layer 41. A desired region of a semiconductor element is formed based on an ion-implanted portion 42 where ions are implanted.

As a result of the ion implantation, the surface of the epitaxial layer 41 including the ion-implanted portions 42 is roughened (the surface of the SiC substrate 40 is damaged so that the degree of planarity deteriorates), as shown in Fig. 2(d).

Then, a treatment for activating the implanted ions and etching of the ion-implanted regions 42 and the like are performed. In this embodiment, these two processes can be performed in a single step. More specifically, a heat treatment (annealing) is performed under Si vapor pressure (under Si atmosphere) and in an environment of 1500°C or more and 2200°C or less and desirably 1600°C or more and 2000°C or less. This can activate the implanted ions. Additionally, the surface of the SiC substrate 40 is etched so that the roughened portions of the ion-implanted regions 42 are planarized (see Fig. 2(e) to Fig. 2(f)).

The above-described process enables the surface of the SiC substrate 40 to obtain a sufficient flatness and electrical activity. The surface of the SiC substrate 40 can be used to manufacture a semiconductor element.

Here, in a portion near the surface of the SiC substrate 40, ion concentration is insufficient since implanted ions are transmitted. In a certain inner portion of the SiC substrate 40, ion concentration is insufficient since implanted ions are not easily reached.

Thus, in etching of Fig. 2(e), it is preferable that too much removal is prevented while removing only the insufficient ion-implanted portion of the surface. In this respect, in this embodiment, the rate of etching can be controlled by adjusting the inert gas pressure. Therefore, the insufficient ion-implanted portion can be surely removed while too much removal of the SiC substrate 40 can be prevented (details thereof will be described later).

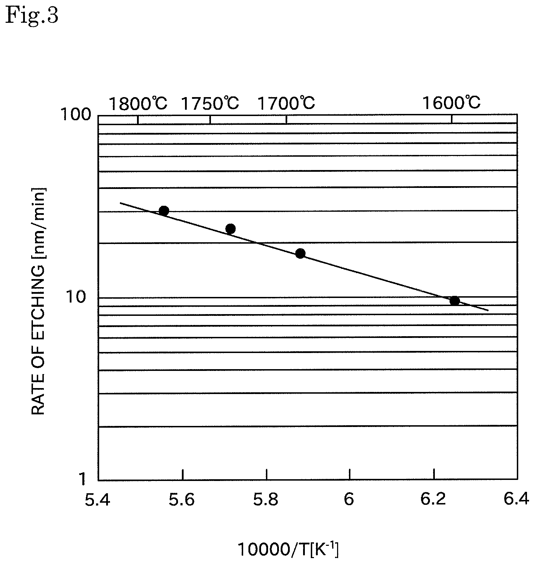

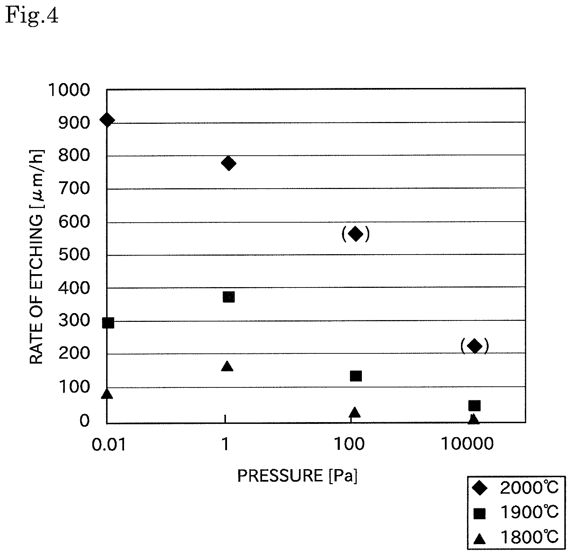

Hereinafter, a relationship between the inert gas pressure and the rate of etching, and the like, will be described with reference to Figs. 3 to Fig. 5. Fig. 3 is a graph showing a relationship between the heating temperature and the rate of etching. Fig. 4 is a graph showing a relationship between the inert gas pressure and the rate of etching for each of heating temperatures.

As conventionally known, the rate of etching of the SiC substrate depends on a heating temperature. Fig. 3 is the graph showing the rate of etching under a predetermined environment in cases where the heating temperature was set to 1600°C, 1700°C, 1750°C, and 1800°C. The horizontal axis of the graph represents the reciprocal of the temperature, and the vertical axis of the graph logarithmically represents the rate of etching. As shown in Fig. 3, the graph is linear. This makes it possible to, for example, estimate the rate of etching that will be obtained if the temperature is changed.

Fig. 4 is the graph showing the relationship between the inert gas pressure and the rate of etching. More specifically, the graph shows the rate of etching determined when changed the inert gas pressure of 0.01 Pa, 1 Pa, 133 Pa, and 13.3 kPa, in an environment in cases where the heating temperature was set to 1800°C, 1900°C, and 2000°C. An object to be treated is a 4H-SiC substrate having an off angle of 4°. Basically, an increase in the inert gas pressure tends to result in a decrease in the rate of etching.

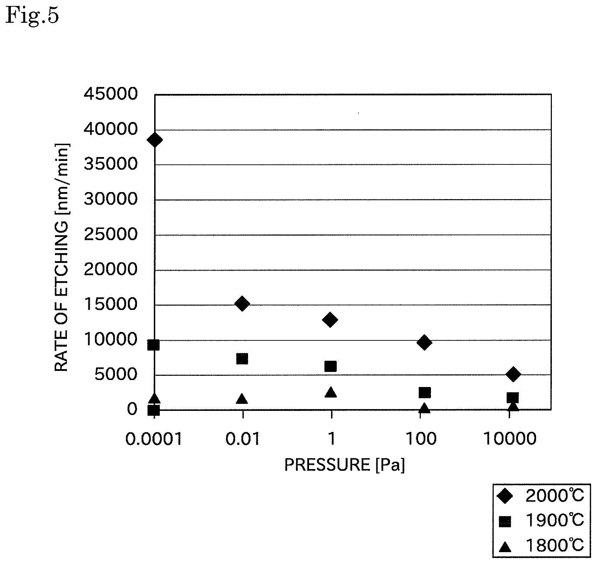

Fig. 5 is the graph showing a relationship between the inert gas pressure and the rate of etching, similarly to Fig. 4. The graph of Fig. 5 shows the rate of etching when the inert gas pressure was set to 0.0001 Pa.

In Patent Document 1, the rate of etching is high since etching is performed under high vacuum. It is therefore difficult to correctly understand the amount of etching. However, as shown in Fig. 4, the rate of etching can be adjusted by changing the inert gas pressure. A low rate of etching, which enables to correctly understand the amount of etching, is very effective in a situation where a slight amount of etching is demanded.

Accordingly, in an etching step for removing latent scratches (Fig. 2(a)), the yield can be improved since the SiC substrate 40 is not too much removed. In the etching step after an epitaxial layer is formed (Fig. 2(e)), too much removal of an ion-implanted portion can be prevented.

In Patent Document 2, performing a hydrogen etching causes a low rate of etching (several tens of nm/h to several hundreds of nm/h), and therefore it takes a lot of time for removing the latent scratches. In this respect, a method in this embodiment has the rate of etching of several µm/h to several tens of µm/h even if the pressure is very high. Therefore, the latent scratches and the insufficient ion-implanted portion can be removed within a practical time.

Particularly when the latent scratches are removed, as shown in an experimental example (details will be described later), the pressure is set to 0.01 Pa to 1 Pa. The rate of etching in this case is 100µm/h or more, and therefore the latent scratches can be more quickly removed.

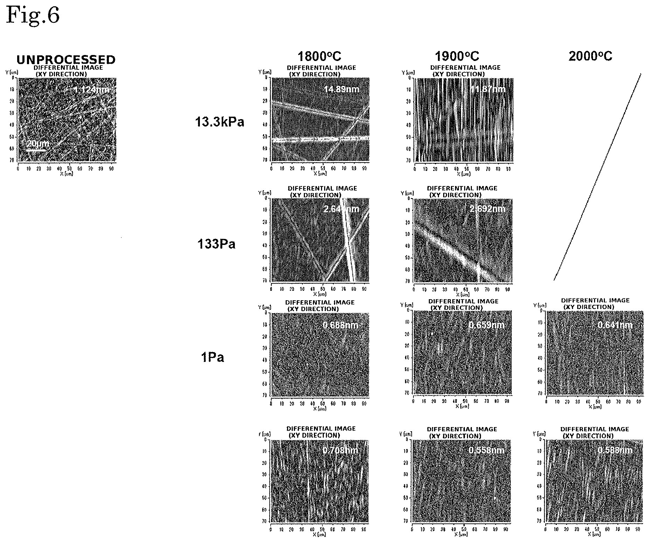

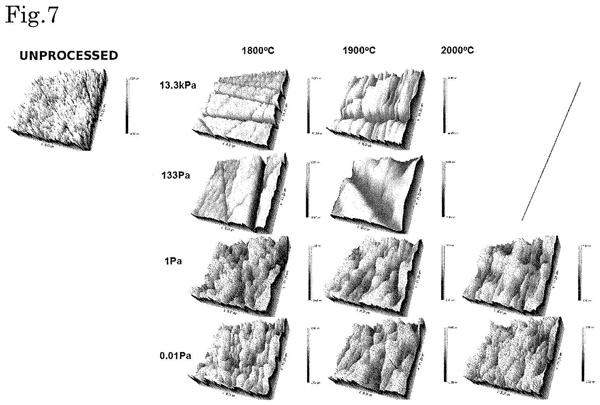

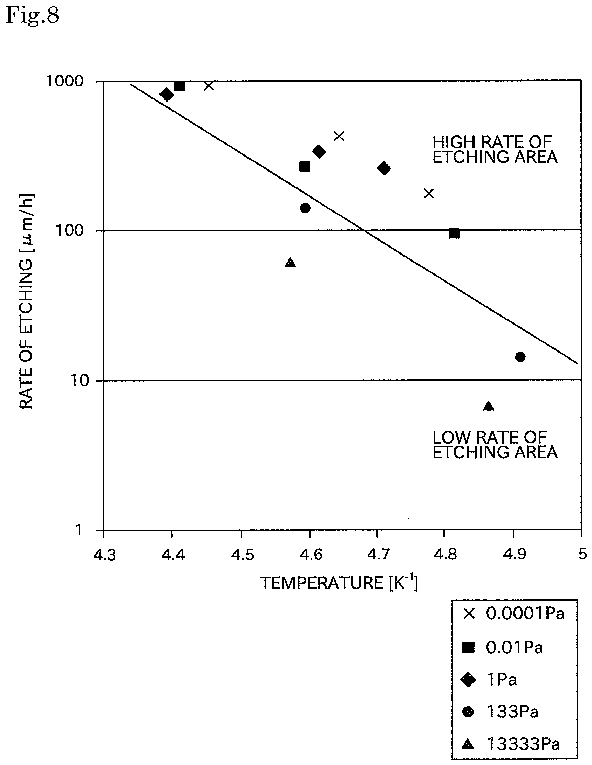

Next, the experimental example in which the latent scratches are removed using the above-described etching process will be described with reference to Fig. 6 to Fig. 8. Fig. 6 contains photomicrographs of a differential interference microscope of a SiC substrate after etched under different heating temperatures and different pressures. Fig. 7 contains diagrams showing three-dimensional shapes of the SiC substrate 40 after etched under different heating temperatures and different pressures. Fig. 8 is a graph showing Arrhenius plot of the rate of etching.

Each of the photographs shown in Fig. 6 is a photomicrograph taken by a differential interference microscope, showing the surface of the SiC substrate at a time of the above-described etching process. Each of the photographs shows a region having about 70µm square. The value written in the upper right corner indicates the surface roughness. Fig. 7 shows three-dimensional shapes of the SiC substrate 40 shown in Fig. 6.

The photograph written UNPROCESSED in the upper left part is that in a case that the etching process is not performed. This photograph shows many fine polishing scratches on the surface.

Photographs when performed etching process under each of the conditions are shown in the right side of the photograph written UNPROCESSED. In these photographs, it can be seen that, when the pressure is 133 Pa or more, the polishing scratches and internal latent scratches are emphasized and scratches are clearly appeared. By contrast, it can be seen that, when the pressure is 1 Pa or less, these scratches are removed.

This would be because, when the pressure is 133 Pa or more, a low rate of etching results in a preferential etching of a low crystallinity portion having the polishing scratches and latent scratches, and therefore scratches are remained (emphasized). By contrast, when the pressure is 1 Pa or less, a high rate of etching results in etching of not only the polishing scratches and latent scratches but also a plane without these scratches. As a result, since the surface of the SiC substrate 40 can be etched uniformly, the above-described scratches can be removed.

Fig. 8 schematically shows the boundary whether or not the above-described latent scratches are removed by using Arrhenius plot of the rate of etching. The horizontal axis of Fig. 8 represents the reciprocal of the temperature, and the vertical axis represents the rate of etching.

Fig. 8 shows the area having a high rate of etching and the area having a low rate of etching. The boundary between these areas is a straight line. The above-described scratches are removed in the area having the high rate of etching, and not removed in the area having the low rate of etching. In Fig. 8, it can be conceivable that not only the rate of etching but also the treatment temperature can determine whether or not the above-described scratches are removed.

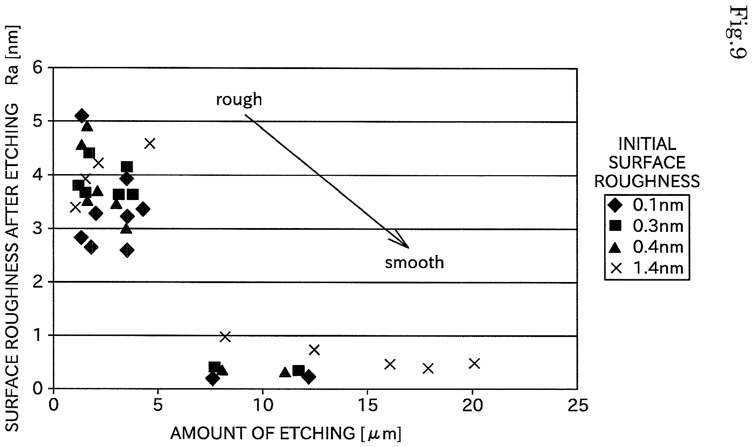

Fig. 9 is a graph showing the measurement result of the surface roughness, in which each of the SiC substrates having the surface roughness of 0.1nm, 0.3nm, 0.4nm and 1.4nm after the mechanical processing is etched in the predetermined amount. The amount of etching of about 1-4µm results in the surface roughness Ra of 2.5nm or more that is considerably increased rather than the surface roughness immediately after the mechanical processing, and the latent scratches of the SiC substrate are obviously appeared. Accordingly, it can be seen that the latent scratches are existing on the SiC substrate performed the mechanical processing.

It is described that the surface roughness is 1nm or less at a stage of further etching of 5µm or more and thereby a smooth surface can be obtained. It is also described that the latent scratches are further removed by etching of 7µm or more, and then the smooth surface can be obtained by further etching of 10µm or more. Moreover, this method can confirm that the latent scratches are existing by etching of 0.5µm to 4µm, preferably 1µm to 3µm.

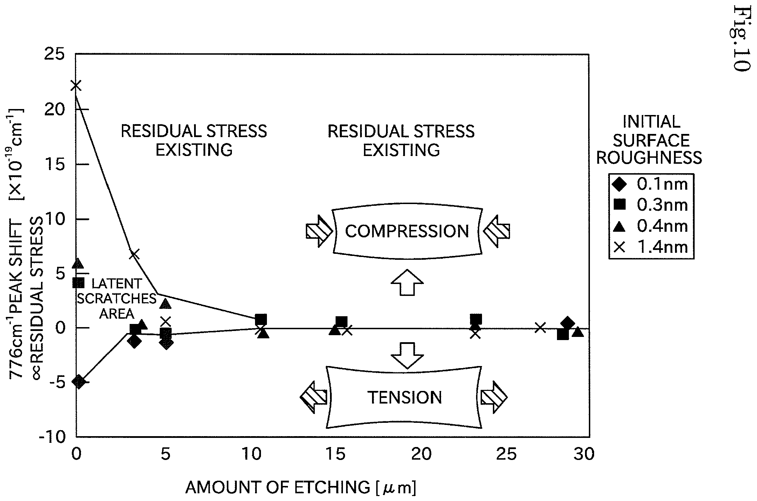

Fig. 10 is a measurement result of a peak shift in Raman spectroscopy when performed etching in the predetermined amount, similarly to Fig. 9. Specifically, Raman spectroscopy is, in the SiC substrate in a backscattering geometry, to measure a peak of 776cm⁻¹ in 4H-SiC FTO mode using Ar laser having wavelength of 532nm as a light source, and then to measure a peak shift depending on the amount of displacement of the peak from the position of the original 776cm⁻¹. Although the residual stress is occurred in the SiC substrate by changing the crystal structure caused from the stress due to the mechanical processing, measuring the peak shift Δω can estimate the residual stress near the surface of the SiC substrate according to the principle that "the residual stress σ has approximate linear characteristics to the peak shift, σ=A×Δω, and A is a constant."

Before etching (when the amount of etching is 0), it can be seen that the peak shift is positioned at a numerical value considerably away from 0 and the relatively large residual stress is existing. In this method, the latent scratches of the SiC substrate can be detected without etching. Similarly to Fig. 9, it can be seen that the peak shift is considerably reduced by etching of 5µm or more and then the latent scratches are removed. The peak shift is further reduced and the latent scratches are removed by etching of 10µm or more.

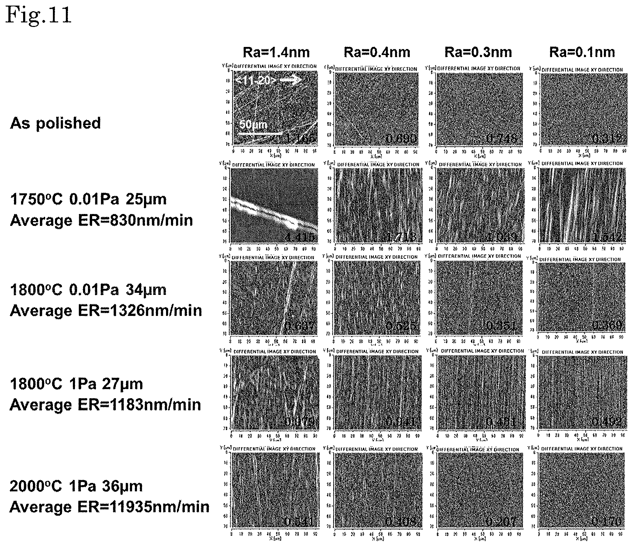

Next, an experiment performed for evaluating the conditions for suppressing a step bunching will be described with reference to Fig. 11 to Fig. 14. In Fig. 11 to Fig. 13, the value written in the lower right corner in each of the photomicrographs shows the surface roughness after processing.

Fig. 11 shows the result observed on the surface after etching up to a certain depth (about 30µm) where the latent scratches may be sufficiently removed. This experiment was performed to the SiC substrate having the surface roughness (Ra) of 1.4nm, 0.4nm, 0.3nm and 0.1nm after performing the mechanical processing. The experiment was also performed with the various rate of etching by changing the inert gas pressure or heating temperature.

The photograph at the second line from the top of Fig. 11 shows the result performed by the process in a slight lower rate of etching (1750°C, 0.01 Pa). As shown in Fig. 11, the step bunching can be seen in the photograph at the second line from the top of Fig. 11.

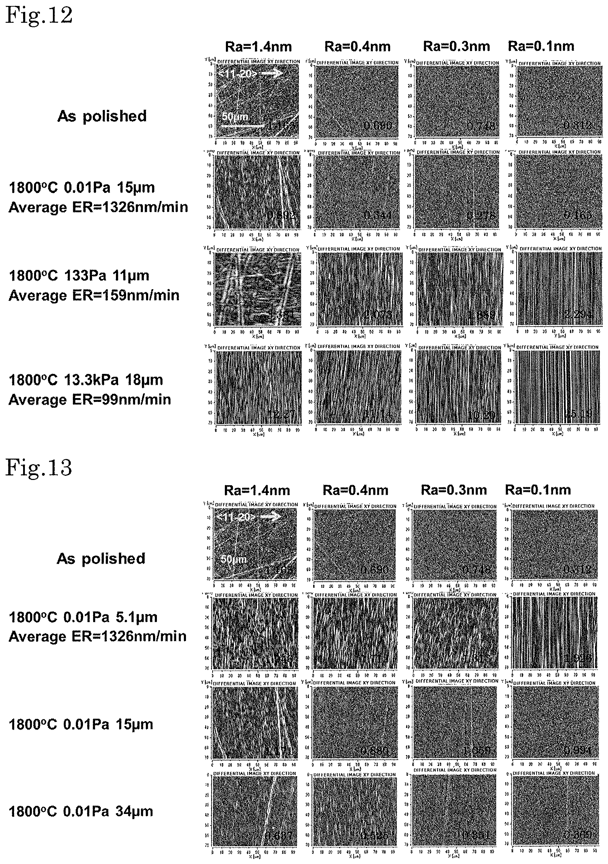

Fig. 12 shows, in 4H-SiC substrate having the off angle of 4°, the result observed on the surface after etching up to a certain depth (about 10µm to 20µm) where the latent scratches may remain. This experiment was performed to the SiC substrate having the surface roughness (Ra) of 1.4nm, 0.4nm, 0.3nm and 0.1nm after performing the mechanical processing. The experiment was also performed with the various rate of etching by changing the inert gas pressure or heating temperature.

As shown in Fig. 12, in the inert gas pressure of 133Pa, the latent scratches may remain since the amount of etching is 11µm. Also in the inert gas pressure of 13.3 kPa, the step bunching is formed on all SiC substrates having various surface roughness. Therefore, the step bunching seen in Fig. 12 would be occurred because of the low rate of etching, as well as the experiment shown in Fig. 11.

Fig. 13 shows, in 4H-SiC substrate having the off angle of 4°, the result observed on the surface after etching at a certain rate of etching capable of sufficiently breaking down (suppressing) the step bunching. This experiment was performed with the various amount of etching, to the SiC substrate having the surface roughness (Ra) of 1.4nm, 0.4nm, 0.3nm and 0.1nm after performing the mechanical processing. The experiment was also performed with the various rate of etching by changing the inert gas pressure or heating temperature.

As shown in Fig. 13, in the amount of etching of about 5µm, the step bunching is formed. In the amount of etching of 15µm and 34µm, the step bunching is suppressed. Therefore, in the amount of etching of about 5µm, the removal of the latent scratches is insufficient. Then, the step bunching that is caused by the remaining latent scratches would be occurred.

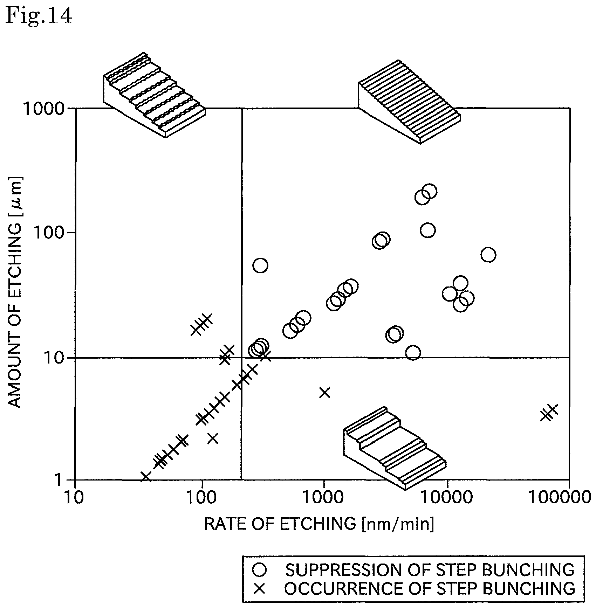

Accordingly, in order to suppress the occurrence of the step bunching when Si etching is performed to the SiC substrate, the rate of etching has to be larger than a predetermined rate and the amount of etching has to be deeper than the predetermined amount. Fig. 14 is a graph plotted whether the step bunching is suppressed or occurred, as a result of heating of 4H-SiC substrate having the off angle of 4° under the condition that the heating temperature is 1800°C or more and 2000°C or less and the inert gas pressure (argon pressure) is 10⁻⁵Pa to 13.3 kPa. Fig. 14 reveals that the step bunching can be suppressed in a case of the amount of etching >10µm and the rate of etching > 200nm/min. The step bunching having a zigzagged edge of a terrace is existing in the case of the amount of etching > 10µm and the rate of etching < 200nm/min. The step bunching having a straight edge of the terrace is existing in a case of the amount of etching < 10µm and the rate of etching > 200nm/min.

As described above, in this embodiment, the process for controlling the rate of etching by adjusting the inert gas pressure, and the process for etching by heating the SiC substrate 40 after performing the mechanical processing are performed.

Accordingly, the latent scratches or the like can be removed if the latent scratches or the like are existing. Thus, since the surface is not roughened even when the epitaxial growth, heat treatment and the like are performed, the high-quality SiC substrate can be manufactured. The etching by the above-described method can considerably shorten the process time rather than the use of the mechanical polishing, chemical mechanical polishing, and hydrogen etching. Moreover, adjusting the inert gas pressure can adjust the rate of etching, and therefore too much removal of the SiC substrate 40 can be prevented.

In this embodiment, a method for manufacturing the semiconductor including a latent scratches removal step, an epitaxial growth step, and a heat treatment step is provided. In the latent scratches removal step, the surface of the SiC substrate 40 is etched by the above-described surface treatment method. In the epitaxial growth step, the surface of the SiC substrate 40 causes an epitaxial growth of the single crystal SiC. In the heat treatment step, the SiC substrate 40 after performing the epitaxial growth step is heated.

Accordingly, the surface is not roughened when the epitaxial growth, heat treatment and the like are performed. This can manufacture the high-quality semiconductor.

In this embodiment, in the heat treatment step, the SiC substrate 40 is heated and etched while controlling the rate of etching by adjusting the inert gas pressure around the SiC substrate 40 according to the invention as mentioned in claims 1-3.

Thus, the latent scratches removal step and the heat treatment step perform the same processing. This can simplify the steps and can easily perform the processing in the same high-temperature vacuum furnace 10.

Although a preferred embodiment of the present invention has been described above, the above-described configuration can be modified, for example, as follows.

Although the above-described embodiment does not include the process of forming a carbon layer (graphene cap), it is acceptable to perform this process. In such a case, the process of removing the carbon layer, the process of activating ions, and the process of etching the single crystal SiC substrate can be implemented in a single process.

Any method is adoptable for adjusting the inert gas. An appropriate method can be used. During the etching process, the inert gas pressure may be kept constant or may be varied. Varying the inert gas pressure may be employed in a case of, for example, initially setting the high rate of etching and then lowering the rate of etching for fine adjustment.

The environment of the processing, the single crystal SiC substrate used, and the like, are merely illustrative ones, and the present invention is applicable to various environments and various types of single crystal SiC substrates. Moreover, a heating apparatus other than the above-described high-temperature vacuum furnace is adoptable.

In this embodiment, the SiC substrate 40 having the latent scratches is etched for removing the latent scratches, but etching may be performed without checking whether or not the latent scratches are occurred. This can omit the labor for checking whether or not the latent scratches are occurred.

### DESCRIPTION OF THE REFERENCE NUMERALS

- 10: high-temperature vacuum furnace
- 21: main heating chamber
- 22: preheating chamber
- 30: crucible
- 40: SiC substrate

## Claims

1. A surface treatment method for treating a surface of a SiC substrate after performing a mechanical processing, the SiC substrate made of, at least in the surface thereof, single crystal SiC, the method including;
providing a SiC substrate having undergone mechanical processing causing a modified layer referred to as latent scratches in which the crystallinity is changed; and
heating and etching the SiC substrate under Si atmosphere and under a condition that the temperature is 1800°C or more and 2000°C or less and an inert gas pressure around the SiC substrate is 0.01 Pa or more and 1 Pa or less, which leads to removal of the latent scratches.

2. The surface treatment method for treating the SiC substrate according to claim 1, wherein
the surface of 5µm or more in the SiC substrate is removed by the step of heating and etching the SiC substrate under the Si atmosphere.

3. The surface treatment method for treating the SiC substrate according to claim 2, wherein
the rate of etching when the SiC substrate is etched is controlled at 200nm/min or more, and
the amount of etching of the SiC substrate is 10µm or more.

4. A method for manufacturing a semiconductor, the method comprising:
a latent scratches removal step of etching the surface of the SiC substrate by the surface treatment method of the SiC substrate according to any one of claims 1 to 3;
an epitaxial growth step of causing an epitaxial growth of single crystal SiC on the surface of the SiC substrate, the surface where the latent scratches are removed in the latent scratches removal step; and
a heat treatment step of heating the SiC substrate under Si atmosphere after the epitaxial growth step is performed.

5. The method for manufacturing the semiconductor according to claim 4, wherein
in the heat treatment step, the SiC substrate is etched by heating under Si atmosphere while controlling the rate of etching of the SiC substrate by adjusting the inert gas pressure around the SiC substrate.

## Patentansprüche

1. Oberflächenbehandlungsverfahren zur Behandlung einer Oberfläche eines SiC-Substrats nach Durchführung einer mechanischen Bearbeitung, wobei das SiC-Substrat zumindest in seiner Oberfläche aus einkristallinem SiC besteht und das Verfahren Folgendes beinhaltet:
Bereitstellen eines SiC-Substrats, das einer mechanischen Bearbeitung unterzogen worden ist, die eine als latente Kratzer bezeichnete modifizierte Schicht verursacht, in der die Kristallinität geändert ist; und
Erhitzen und Ätzen des SiC-Substrats unter Si-Atmosphäre und unter einer Bedingung, dass die Temperatur 1800°C oder mehr und 2000°C oder weniger beträgt und ein Inertgasdruck um das SiC-Substrat herum 0,01 Pa oder mehr und 1 Pa oder weniger beträgt, was zur Entfernung der latenten Kratzer führt.

2. Oberflächenbehandlungsverfahren zur Behandlung des SiC-Substrats nach Anspruch 1, wobei
durch den Schritt Erhitzen und Ätzen des SiC-Substrats unter der Si-Atmosphäre 5 µm oder mehr der Oberfläche in dem SiC-Substrat entfernt wird.

3. Oberflächenbehandlungsverfahren zur Behandlung des SiC-Substrats nach Anspruch 2, wobei
die Ätzrate beim Ätzen des SiC-Substrats auf 200 nm/min oder mehr gesteuert wird und
die Menge des Ätzens des SiC-Substrats 10 µm oder mehr beträgt.

4. Verfahren zur Herstellung eines Halbleiters, wobei das Verfahren Folgendes umfasst:
einen Latentkratzer-Entfernungsschritt, in dem durch das Oberflächenbehandlungsverfahren des SiC-Substrats gemäß einem der Ansprüche 1 bis 3 die Oberfläche des SiC-Substrats geätzt wird;
einen epitaktischen Wachstumsschritt, in dem auf der Oberfläche des SiC-Substrats, wo in dem Latentkratzer-Entfernungsschritt die latenten Kratzer entfernt worden sind, ein epitaktisches Wachstum von einkristallinem SiC bewirkt wird; und
einen Wärmebehandlungsschritt, in dem das SiC-Substrat unter Si-Atmosphäre erhitzt wird, nachdem der epitaktische Wachstumsschritt durchgeführt worden ist.

5. Verfahren zur Herstellung des Halbleiters nach Anspruch 4, wobei
das SiC-Substrat im Wärmebehandlungsschritt geätzt wird, indem es unter Si-Atmosphäre erhitzt wird, während die Ätzrate des SiC-Substrats durch Einstellen des Inertgasdrucks um das SiC-Substrat herum gesteuert wird.

## Revendications

1. Procédé de traitement de surface pour traiter une surface d'un substrat en SiC après mise en œuvre d'un traitement mécanique, le substrat en SiC étant fait, au moins dans sa surface, de SiC monocristallin, le procédé comprenant :
l'obtention d'un substrat en SiC ayant subi un traitement mécanique engendrant une couche modifiée qualifiée de rayures latentes dans lesquelles la cristallinité est changée ; et
le chauffage et la gravure du substrat en SiC dans une atmosphère de Si et dans des conditions telles que la température soit de 1800°C ou plus et de 2000°C ou moins, la pression de gaz inerte autour du substrat en SiC étant de 0,01 Pa ou plus et de 1 Pa ou moins, ce qui conduit au retrait des rayures latentes.

2. Procédé de traitement de surface pour traiter une surface d'un substrat en SiC selon la revendication 1, dans lequel une surface de 5 µm ou plus dans le substrat en SiC est retirée par l'étape de chauffage et de gravure du substrat en SiC dans l'atmosphère de Si.

3. Procédé de traitement de surface pour traiter une surface d'un substrat en SiC selon la revendication 2, dans lequel
la vitesse de gravure quand le substrat en SiC est gravé est contrôlée à 200 nm/min ou plus, et
la quantité de gravure du substrat en SiC est de 10 µm ou plus.

4. Procédé pour fabriquer un semi-conducteur, le procédé comprenant :
une étape de retrait des rayures latentes consistant à graver la surface du substrat en SiC par le procédé de traitement de surface du substrat en SiC selon l'une quelconque des revendications 1 à 3 ;
une étape de croissance épitaxiale consistant à provoquer une croissance épitaxiale de SiC monocristallin sur la surface du substrat en SiC, la surface où les rayures latentes sont retirées dans l'étape de retrait des rayures latentes ; et
une étape de traitement à la chaleur consistant à chauffer le substrat en SiC dans une atmosphère de Si après que l'étape de croissance épitaxiale a été effectuée.

5. Procédé pour fabriquer un semi-conducteur selon la revendication 4, dans lequel, dans l'étape de traitement à la chaleur, le substrat en SiC est gravé par chauffage dans une atmosphère de Si cependant que la vitesse de gravure du substrat en SiC est contrôlée par ajustement de la pression de gaz inerte autour du substrat en SiC.
